# EUROPÄISCHE PATENTSCHRIFT

(11) **EP 2 142 679 B1**
(45) Veröffentlichungstag und Bekanntmachung des Hinweises auf die Patenterteilung: **22.05.2013**
(21) Anmeldenummer: 08715554.5
(22) Anmeldetag: 10.03.2008
(51) Int. Cl.: C23C 4/10, C23C 4/12, C23C 14/56, H01J 37/32, H05H 1/42, C23C 16/455

(54) **VERFAHREN ZUR PLASMAGESTÜTZTEN OBERFLÄCHENBEHANDLUNG GROßVOLUMIGER BAUTEILE**
METHOD FOR THE PLASMA-ASSISTED SURFACE TREATMENT OF LARGE-VOLUME COMPONENTS
PROCÉDÉ POUR TRAITEMENT DE SURFACE PAR PLASMA DE COMPOSANTS DE GRAND VOLUME

(30) Priorität: 09.03.2007 DE 102007011961
(43) Veröffentlichungstag der Anmeldung: 13.01.2010
(73) Patentinhaber: Dr. Laure Plasmatechnologie Gmbh, 70329 Stuttgart (DE)
(72) Erfinder: LAURE, Stefan, 70329 Stuttgart (DE)
(74) Vertreter: Geitz Truckenmüller Lucht
(86) Internationale Anmeldenummer: PCT/DE2008/000410
(87) Internationale Veröffentlichungsnummer: WO 2008/110151

(56) Entgegenhaltungen:
- EP-A- 1 265 268
- EP-A- 1 354 640
- WO-A-2005/069703
- WO-A-2006/108395
- WO-A1-01/45862
- US-A- 4 445 991

## Beschreibung

### Stand der Technik

Die Erfindung geht aus von einem Verfahren und einer Vorrichtung zur plasmagestützten Oberflächenbehandlung großvolumiger Bauteile.

Wird die Oberfläche eines Bauteils einem Plasma ausgesetzt, so können bei entsprechender Wahl der Plasmaparameter wie Druck, Temperatur und Plasmazusammensetzung die Funktionalität und die Eigenschaften der Oberfläche gezielt beeinflusst und verändert werden. Aus dem Stand der Technik sind Verfahren zur Behandlung, Modifizierung oder Beschichtung einer Oberfläche aus beliebigem Material bekannt, bei denen Teilchen- oder Energieströme aus einem Plasma genutzt werden. Hierzu zählen unter anderem Plasmaspritzen, Lichtbogenplasmaschmelzen, Plasmawärmebehandlungsverfahren, Plasma-CVD-Verfahren und Plasmareinigung. Die Veränderung der Funktionalität von Werkstückoberflächen erfolgt durch die Wechselwirkung mit Teilchen mit bestimmten chemischen Eigenschaften oder durch die Einwirkung von Strahlung, die im Plasma emittiert wird.

Zur Erzeugung eines Plasmas wird ein Plasmabrenner verwendet, beispielsweise ein Lichtbogen-Plasmagenerator, ein Hochfrequenz-Plasmagenerator oder ein Mikrowellenplasmagenerator.

Thermische Plasmen eignen sich für die Bearbeitung von Bauteilen, die sich durch eine gewisse Temperaturelastbarkeit auszeichnen. Bei Bauteilen aus Kunststoff oder bei bereits lackierten oder beschichteten Bauteilen, die einer maximalen Temperatur von nur 100-200°C ausgesetzt sein dürfen, können derartige Verfahren nicht eingesetzt werden.

Eine Plasmabehandlung mit bekannten Plasmageneratoren ist zwar bei kleinen Bauteilen angemessen, jedoch eignet sie sich für große Bauteile nicht. Das Plasma tritt nur in einem eng begrenzten Bereich auf und bildet sich nicht über das gesamte Bauteil aus. Zur Plasmabehandlung der gesamten Oberfläche eines großen Bauteils muss daher der Plasmastrahl über das Bauteil geführt werden. Dies ist bei Bauteilen wie beispielsweise Karosserien von Fahrzeugen mit einem hohen Zeit- und Kostenaufwand verbunden.

Zur Erzeugung von dünnen Plasmen mit relativ geringen Energiedichten werden ebenfalls Hochfrequenzgeneratoren benutzt. Ihr Frequenzbereichbereich liegt zwischen einigen hundert Kilohertz und mehreren zehn Gigahertz. Das Plasma wird an den Oberflächen von Elektroden oder Antennen quellförmig erzeugt und breitet sich in den Raum aus. Als nachteilig erweist sich, dass sich die Zusammensetzung und die Temperatur des Plasmas mit wachsendem Abstand vom Plasmabrenner verändert. Dadurch wird eine gleichmäßige Oberflächenbehandlung eines Bauteils unmöglich oder zumindest erschwert.

Darüber hinaus eignen sich die bekannten Verfahren nicht zur Behandlung von Spalten, Fügestellen, Hohlräumen und Hinterschneidungen, welche bei Karosserien von Fahrzeugen auftreten. Die der Plasmaquelle abgewandten Flächen sind keinem gleichmäßigen Plasma ausgesetzt. Auf den der Plasmaquelle zugewandten Flächen kann aufgrund der starken Gradienten eine gleichmäßige Bearbeitung nicht garantiert werden. Dies gilt vor allem für Bearbeitungsvorgänge, die von Strahlungsprozessen dominiert werden.

Patentdokument WO2006/108395 offenbart ein Verfahren zur Plasmabehandlung von Bauteilen in einer Vakuumkammer.

### Die Erfindung und ihre Vorteile

Demgegenüber haben das erfindungsgemäße Verfahren mit den Merkmalen des Anspruchs 1 den Vorteil, dass das Bauteil selbst Teil des Plasmagenerators ist, und sich daher das Plasma an der gesamten Oberfläche des Bauteils ausbreitet. Das Bauteil wird über seine gesamte Oberfläche einer gleichmäßig wirkenden Plasmabehandlung unterzogen. In die Vakuumkammer wird als Arbeitsgas und/ oder als Trägergas Stickstoffoxid eingeleitet. Hierzu zählen beispielsweise Stickstoffmonoxid, Stickstoffdioxid, Distickstofftmonoxid, Distickstoffdioxid, Stickstofftrioxid, Distickstofftrioxid, Distickstoffquatroxid und Distickstoffpentoxid. Es können auch Mischungen verschiedener Stickstoffoxide eingesetzt werden. Bei der Umsetzung von Stickstoffoxid im Plasma entsteht UV-Strahlung. Außerdem entstehen freie Elektronen und damit eine hohe Elektronendichte im Plasma an der Oberfläche des Bauteils. Zusätzlich werden Excimere oder Exciplexe in die Vakuumkammer eingeleitet. Die Umwandlung der Stoffe findet direkt an der Oberfläche des Bauteils in dem dort brennenden Plasma statt. Die UV-Strahlung und/ oder die Elektronen dienen dazu, die Oberfläche des Bauteils zu behandeln. Da sich das Plasma an der gesamten Oberfläche des Bauteils ausbreitet, wirken die UV-Strahlung und die Elektronen auf die gesamte Oberfläche des Bauteils ein. Dies gilt für die Innen- und Außenseite eines Bauteils, Hohlräume, Spalte, Fügestellen, Hinterschneidungen und Schlitze. Die Wellenlänge der UV-Strahlung und die Elektronendichte sind variabel und werden durch die Zusammensetzung des Arbeits- und/ oder Trägergases und die Komponenten des Schwingkreises eingestellt, insbesondere durch die Anregungsfrequenz, die Kapazitäten des Schwingkreises und des Bauteils und die Induktivitäten des Schwingkreises und des Bauteils. Dabei sind die Induktivität und die Kapazität des Bauteils vorgegeben. Alle anderen Komponenten und die zugehörigen Parameter sind einstellbar. Das Verfahren zeichnet sich aufgrund der vielen einstellbaren Parameter durch eine hohe Flexibilität und Variabilität der an den Oberflächen eines Bauteils zu erzeugenden UV-Strahlung und der Elektronendichte aus. Je nach Plasmagasgemisch liegen die Wellenlängen in einem Bereich zwischen 200 und 400 nm. Die Breite des Bereichs hängt ebenfalls von dem Plasmagasgemisch aus Arbeits- und Trägergas ab.

Das Trägergas dient in erster Linie dazu, das Plasma auszubilden. Es wird ionisiert und stellt die Ionen und die freien Elektronen. Das Arbeitsgas dient dazu, das Plasma so zu gestalten, dass es die für die Oberflächenbehandlung des Bauteils notwendigen und gewünschten Eigenschaften aufweist.

Die Flexibilität und Variabilität kann zusätzlich dadurch erhöht werden, dass das Bauteil an mehrere Schwingkreise mit jeweils einem Hochfrequenzgenerator angeschlossen wird. Die Anregungsfrequenzen des ersten und des zweiten sowie gegebenenfalls weiterer Hochfreqenzgeneratoren können identisch oder verschieden sein. Werden alle Hochfrequenzgeneratoren mit derselben Anregungsfrequenz betrieben, so führt dies dazu, dass im Vergleich zu nur einem Hochfrequenzgenerator mehr Leistung im Plasma umgesetzt wird. Werden die Anregungsfrequenzen variiert und für jeden Schwingkreis unterschiedlich eingestellt, so können unterschiedliche Anregungsmodi im Plasma aktiviert werden. In diesem Fall wird die Vorrichtung als Multifrequenzplasmaerzeuger betrieben.

Das erfindungsgemäße Verfahren kann bei beliebigen Bauteilen unterschiedlicher Größe eingesetzt werden. Da das Bauteil Teil des Schwingkreises zur Plasmaerzeugung ist, und sich das Plasma an der Oberfläche des Bauteils ausbildet, ist keine Anpassung der Geometrie der Vorrichtung an verschiedene Bauteile notwendig. Eine kalte Grenzschicht an der Oberfläche des Bauteils kann nicht auftreten. Das erfindungsgemäße Verfahren eignet sich insbesondere für große Bauteile wie beispielsweise Fahrzeugkarosserien, Flugzeug- und Maschinenteile, um nur einige Beispiele zu nennen. Voraussetzung hierzu ist, dass die Vakuumskammer die notwendige Größe aufweist, und dass das Bauteil in die Vakuumkammer eingeführt und gegen die Vakuumkammer isoliert werden kann. Zum Einführen des Bauteils in die Vakuumkammer und zum Ausführen des Bauteils aus der Vakuumkammer kann die Vakuumkammer mit einer Transporteinrichtung ausgestattet sein.

Das Bauteil wird in eine Vakuumkammer der Vorrichtung eingebracht. Hierzu dient vorzugsweise ein Transporteinrichtung. Anschließend wird das Bauteil an den ersten Schwingkreis mit erstem Hochfrequenzgenerator angeschlossen oder an den ersten Schwingkreis zumindest teilweise berührungsfrei gekoppelt. Hierzu wird das Bauteil galvanisch, kapazitiv oder induktiv in den Schwingkreis eingebunden. Es besteht auch die Möglichkeit, Mischformen der Ankopplung zu verwenden. Das Bauteil kann beispielsweise an einem Pol galvanisch und an dem anderen Pol kapazitiv an den Schwingkreis angekoppelt werden. Eine induktive Ankopplung erfolgt beispielsweise über eine Spule, die nahe dem Bauteil in der Vakuumkammer angeordnet wird. Das Bauteil bildet damit einen Teil des ersten Schwingkreises. Um die optimale Ankopplung der elektrischen Leistung an das Bauteil sicherzustellen, muss der Schwingkreis, der aus dem zu bearbeitenden Bauteil und den zusätzlichen Kapazitäten und Induktivitäten besteht, entsprechend angepasst werden. Dies geschieht durch die Variation der Kapazitäten und Induktivitäten des Schwingkreises. Die Einstellung der Kapazitäten und Induktivitäten des Schwingkreises kann entweder manuell oder automatisch erfolgen. Bei einer automatischen Einstellung werden zunächst die Kapazität und die Induktivität des Bauteils ermittelt. Die Variation der Kapazitäten und Induktivitäten des Schwingkreises bewirkt eine Veränderung der Frequenz des Schwingkreises.

Die Stickstoffoxide emittierten bei ihrer Anregung im Plasma eine elektromagnetische Strahlung im Wellenlängenbereich zwischen 220 und 400 nm.

Zusätzlich zu dem Stickstoffoxid oder den Stickstoffoxiden werden Excimere oder Exciplexe in die Vakuumkammer eingeleitet. Diese sind aus der Lasertechnik bekannt. Excimere und Exciplexe bestehen aus mindestens zwei Atomen, von denen mindestens eines in einem angeregten Zustand ist. Bei der Rückkehr des angeregten Atoms in den Grundzustand wird eine UV-Strahlung diskreter Wellenlänge abgestrahlt.

Mit dem erfindungsgemäßen Verfahren sind unterschiedliche Bearbeitungen des Bauteils möglich. Durch die UV-Strahlung und/ oder die hohe Elektronendichte ist eine Umsetzung von Doppelbindungen in Beschichtungen des Bauteils möglich. Dies führt zu einer Härtung der Beschichtung. Dabei kann es auch zu einer Vernetzung der Beschichtung kommen. Bei der Beschichtung kann es sich beispielsweise um einen Lack handeln. Erfolgt die Härtung der Beschichtung durch die freien Elektronen, kann auf Photoinitiatoren in der Beschichtung verzichtet werden.

Das Plasma wird durch die Ausbildung von Wirbelströmen an der Oberfläche des Bauteils erzeugt. Der durch das Bauteil fließende Wechselstrom bewirkt oszillierende Magnetfelder, die sich abhängig von der Geometrie des Bauteils in dessen Umgebung ausbreiten. Die zeitliche Änderung des Magnetfelds führt zu elektrischen Feldern, die für die Erzeugung und Aufrechterhaltung des Plasmas in der Umgebung des Bauteils verantwortlich sind.

Nach einer vorteilhaften Ausgestaltung der Erfindung wird in die Vakuumkammer zusätzliche als Trägergas und/ oder Arbeitsgas Stickstoff oder Ammoniak eingeleitet. Mit ihnen kann die Wellenlänge der UV-Strahlung variiert werden. Ammoniak hat ferner die Eigenschaft den aus dem Stickstoffoxid frei werdenden Sauerstoff zu binden und damit eine Oxidation der Oberfläche des Bauteils zu verhindern.

Nach einer weiteren vorteilhaften Ausgestaltung der Erfindung werden als Trägergas ein Edelgas und/ oder einen Stoff eingeleitet, der Sauerstoff bindet. Wird als Trägergas ein Edelgas eingesetzt, so beeinflusst dieses die durch das Stickstoffoxid erzeugte UV-Strahlung nicht. Stoffe, die Sauerstoff binden, haben den Vorteil, dass sie den aus dem Stickstoffoxid frei werdenden Sauerstoff binden und damit eine Oxidation der Oberfläche des Bauteils verhindern. Nach einer weiteren vorteilhaften Ausgestaltung der Erfindung wird das Trägergas und/ oder das Arbeitsgas über Düsen in die Vakuumkammer eingeleitet. Dabei wird ein Teilchenstrom um das Bauteil herum erzeugt. Dieser umströmt das Bauteil auf einer Kreisbahn oder nahezu einer Kreisbahn. Der Verlauf der Strömung wird durch die Form der Vakuumkammer unterstützt und beeinflusst. Dadurch wird erreicht, dass das Plasma gleichmäßig an der Oberfläche des Bauteils brennt und sich kein Plasmastrahl ausbildet, der vom Bauteils weg oder auf das Bauteil zu gerichtet ist. Ein derartiger Plasmastrahl würde zur Beschädigung des Bauteils führen. Aufgrund des kreisförmigen Verlaufs wird die Strömung auch als Zyklonströmung bezeichnet. Die Strömung kann entweder allein durch das Trägergas oder allein durch das Arbeitsgas oder durch beide Gase erzeugt werden. Wird nur eines der beiden Gase oder Gasgemische derart in die Vakuumkammer eingeleitet, dass sich eine Zyklonströmung ausbildet, so kann das andere Gas oder Gasgemisch axial oder radial dazu in die Vakuumkammer eingeführt werden.

Nach einer weiteren vorteilhaften Ausgestaltung der Erfindung wird das Arbeitsgas über Düsen parallel oder senkrecht zur Längsachse der Vakuumkammer in die Vakuumkammer eingeleitet. Es mischt sich anschließend mit dem Trägergas. Die Düsen behindern ferner das Einführen des Bauteils in die Vakuumkammer nicht.

Nach einer weiteren vorteilhaften Ausgestaltung der Erfindung wird das Arbeitsgas dem Trägergas vor dem Einleiten in die Vakuumkammer beigemischt. In diesem Fall sind keine speziellen Düsen zum Einleiten des Arbeitsgases notwendig.

Nach einer weiteren vorteilhaften Ausgestaltung der Erfindung wird mindestens eine Verbindung, welche eine oder mehrere Carbonyl-Gruppen enthält, in die Vakuumkammer eingeleitet. Die Verbindung dient der Verbreiterung des Strahlungsspektrums im Plasma.

Nach einer weiteren vorteilhaften Ausgestaltung der Erfindung wird eine Methylen oder Methylen-Gruppen enthaltende Verbindung in die Vakuumkammer eingeleitet. Diese Verbindung dient ebenfalls der Verbreiterung des Strahlungsspektrums im Plasma.

Nach einer vorteilhaften Ausgestaltung der Vorrichtung sind in der Vakuumkammer mehrere Düsen zum Einleiten des Stickstoffsoxids angeordnet. Die Düsen können beispielsweise mit ihrer Düsenachse parallel zu einer den Düsen nahe gelegenen Wand der Vakuumkammer ausgerichtet sein. Diese Anordnung ermöglicht und unterstützt das Ausbilden eines Teilchenstroms aus Stickstoffoxid um ein Bauteil herum, welches in der Vakuumkammer angeordnet ist. Es entsteht eine Zyklonströmung, die das Bauteil kreisförmig umströmt. Dadurch wird verhindert, dass sich ein auf das Bauteil gerichteter oder von dem Bauteil wegführender Plasmastrahl aufbaut.

Nach einer weiteren vorteilhaften Ausgestaltung der Vorrichtung weist die Einrichtung zum Einleiten des Stickstoffoxids ein Rohr auf. Die Düsen sind in oder an dem Rohr angeordnet. Das Rohr kann beispielweise entlang der Wand der Vakuumkammer verkaufen.

Nach einer weiteren vorteilhaften Ausgestaltung der Vorrichtung ist zusätzlich mindestens ein Mikrowellenplasmagenerator vorgesehen. Die Mikrowellenplasmageneratoren dienen dazu, an bestimmten Stellen eine konstante Teilchen- oder Energiedichte des Plasmas zu unterstützen, das Plasma zu zünden, insbesondere bei hohen Drücken oder hohen Teilchendichten in der Vakuumkammer, und zur Vorkonditionierung oder Aufbereitung der Arbeitsmedien oder ihrer Komponenten vor oder bei dem Eintritt in die Vakuumkammer. Sie können beispielsweise zur Aufbereitung der Precursorstoffe eingesetzt werden. Vorteilhafterweise ist die Position der Mikrowellenplasmageneratoren einstellbar um sie optimal an das Bauteil anpassen zu können. Zusätzlich dazu besteht die Möglichkeit, die Mikrowellenplasmageneratoren außerhalb der Vakuumkammer anzuordnen und über einen Anschluss an die Vakuumkammer zu koppeln.

Nach einer weiteren vorteilhaften Ausgestaltung der Erfindung wird über den Hochfrequenzgenerator eine Wechselspannung mit 0,1 bis 100 MHz in den Schwingkreis eingespeist. Besonders bevorzugt liegt die Wechselspannung zwischen 1 und 4 MHz.

Nach einer weiteren vorteilhaften Ausgestaltung der Erfindung wird die Vakuumkammer auf einen Druck zwischen 0,05 und 1.000 Pa evakuiert. Im Unterschied zu den aus dem Stand der Technik bekannten Verfahren kann der Arbeitsdruck je nach Anwendung auf einige 10 mbar erhöht werden. Damit steht ein weiteres Werkzeug zur Steuerung der Zahl der Teilchen, die mit der Oberfläche des zu bearbeitenden Bauteils in Wechselwirkung treten, zur Verfügung.

Weitere Vorteile und vorteilhafte Ausgestaltungen der Erfindung sind der nachfolgenden Beschreibungen, der Zeichnung und den Ansprüchen zu entnehmen.

### Zeichnung

In der Zeichnung ist ein Ausführungsbeispiel einer Vorrichtung zur plasmagestützten Oberflächenbehandlung dargestellt. Im folgenden ist diese Vorrichtung erläutert. Es zeigen:
- Figur 1: Vorrichtung zur Plasmabehandlung in einer Ansicht von vorne,
- Figur 2: Vorrichtung zur Plasmabehandlung in einer Ansicht von oben,
- Figur 3: Schaltplan der Vorrichtung gemäß Figur 1 und 2,
- Figur 4: Vorrichtung gemäß Figur 1 mit einem Rohr zum Zuleiten des Stickstoffoxids.

### Beschreibung des Ausführungsbeispiels

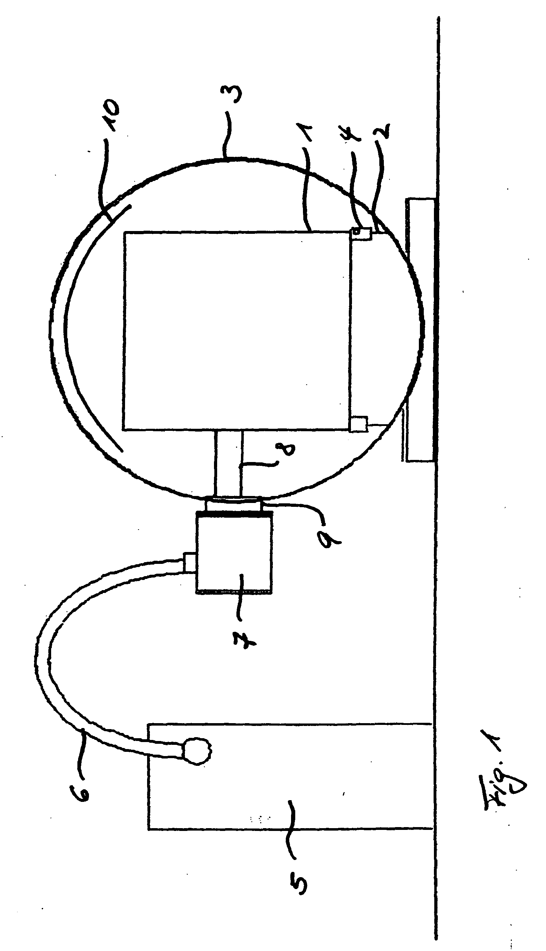

Die Figuren 1 bis 4 zeigen eine Vorrichtung zur plasmagestützten Beschichtung und Oberflächenbehandlung in einer Ansicht von vorne und von oben sowie einen zugehörigen Schaltplan.

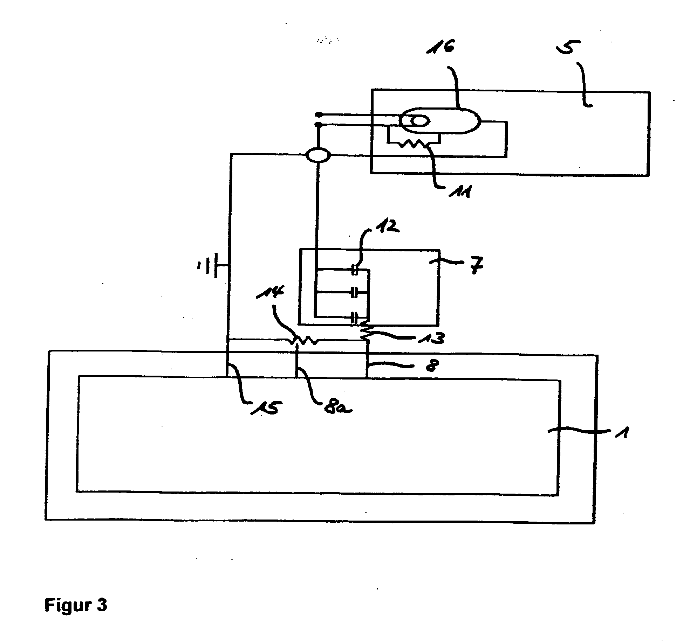

Bei der Vorrichtung gemäß Figuren 1 bis 4 wird ein zu bearbeitendes Bauteil 1 über Schienen 2 und in der Zeichnung nicht erkennbare Rollen in eine Vakuumkammer 3 eingefahren. Schienen und Rollen bilden zusammen eine Transporteinrichtung. Diese kann zusätzlich mit einem Antrieb ausgestattet sein, der in der Zeichnung nicht dargestellt ist. An den Schienen 2 ist eine Isolation 4 vorgesehen, welche das Bauteil 1 gegen die Vakuumkammer 3 isoliert. Mit Erreichen seiner Endposition wird der Kontakt zwischen einem ersten Hochfrequenz-Schwingkreis und dem Bauteil geschlossen. Dies erfolgt über einen in der Zeichnung nicht erkennbaren Gleitkontakt, der durch Formschluss an dem Bauteil 1 haftet. Das Bauteil ist nun Teil eines Schwingkreises. Der Schwingkreis besteht abgesehen vom Bauteil 1 aus einem Hochfrequenzgenerator 5 mit einer in Figur 3 dargestellten Rückkoppelspule 11, einem Koaxial-Kabel 6, einem Außenschwingkreis 7 und einer Hochfrequenz-Zuleitung 8, an deren Enden der Gleitkontakt vorgesehen ist. In der Vakuumkammer 3 ist eine Hochfrequenz-Durchführung 9 für die Hochfrequenz-Zuleitung 8 vorgesehen. Oberhalb des Bauteils ist ein Reflektor 10 für das Plasma vorgesehen.

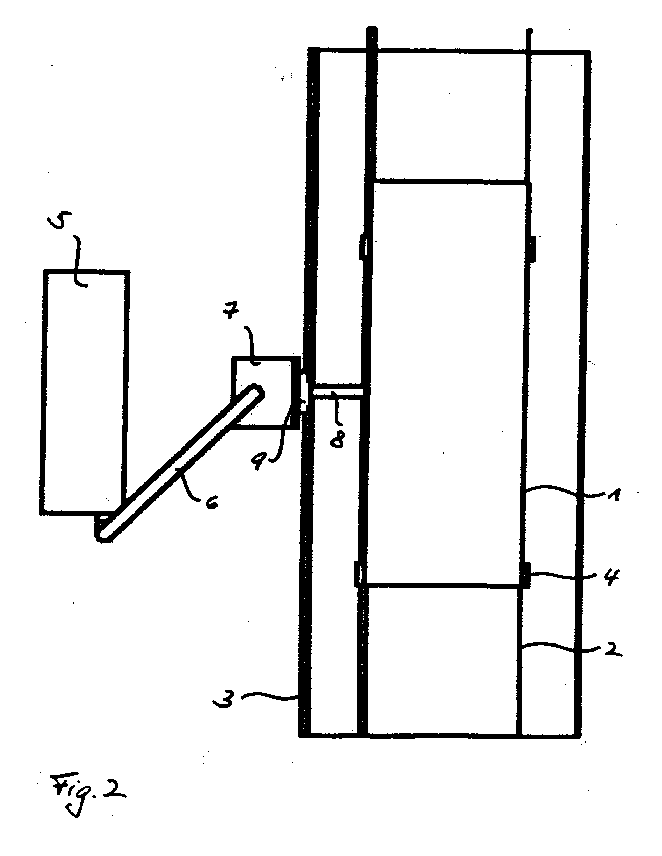

Figur 3 zeigt schematisch den Schaltplan der Vorrichtung gemäß Figuren 1 und 2. Der Hochfrequenzgenerator 5 versorgt den ersten Schwingkreis über ein Koaxial-Kabel 6 mit Wechselstrom. Der erste Hochfrequenzgenerator 5 verfügt über eine Rückkoppelspule 11, deren Induktivität automatisch einstellbar ist. Derjenige Teil des Schwingkreises, der sich außerhalb der Vakuumkammer befindet, wird als Außenschwingkreis 7 bezeichnet. Im Außenschwingkreis 7 sind drei Kondensatoren 12 vorgesehen. Sie können alle oder nur teilweise in den Schwingkreis integriert werden um die Gesamtkapazität zu verändern. Die Induktivität des Schwingkreises wird auch durch das Bauteil 1 bestimmt. Das Bauteil 1 ist über die Hochfrequenz-Zuleitung 8 mit dem Außenschwingkreis 7 verbunden. Um die Induktivität des Schwingkreises auf das Bauteil abzustimmen, ist eine Spule 13 am Außenschwingkreis vorgesehen. Zusätzlich dazu ist eine weitere Spule 14 mit einem Abgriff an der Hochfrequenz-Zuleitung 8 unmittelbar an der Spule 13 vorgesehen. Diese wird nur bei Bedarf zur Anpassung der Gesamtinduktivität in den Schwingkreis integriert. Für diesen Fall wird anstelle der Hochfrequenz-Zuleitung 8 die Hochfrequenz-Zuleitung 8a verwendet. Das Bauteil 1 kann optional über die Leitung 15 geerdet werden.

Durch Einspeisen eines hochfrequenten Wechselstroms bei sehr niedriger Leistung wird der Kontakt zwischen Bauteil 1 und dem übrigen Schwingkreis überprüft. Erfüllt der Kontakt die Anforderungen, so wird die Vakuumkammer 3 evakuiert. Nachdem der Druck in der Vakuumkammer 3 einen bestimmten, von der Art der Behandlung abhängigen Wert erreicht hat, wird hochfrequenter Wechselstrom in den Schwingkreis eingespeist. Außerdem wird ein Trägergas in die Vakuumkammer eingeleitet, das bei der Zündung des Plasma ionisiert wird. An der Oberfläche des Bauteils 1 entsteht das Plasma, welches für die Behandlung des Bauteils benötigt wird. Die Steuerung des Plasmaeinflusses an der Oberfläche des Bauteils erfolgt durch die Regelung der Anodenspannung einer Senderöhre 16, die den Wechselstrom in den Schwingkreis einspeist. Durch Überwachung der Strom-Spannungskennlinie der Senderöhre 16 des Schwingkreises wird die Effizienz der Einkopplung der elektrischen Leistung in das Plasma kontrolliert. Die Feinabstimmung des Schwingkreises während der Plasmabehandlung erfolgt durch Variation der Induktivität der Rückkoppelspule des Schwingkreises. Im Vorfeld besteht zusätzlich die Möglichkeit, die Grobabstimmung des Systems durch Einfügen zusätzlicher Induktivitäten 14 oder Kapazitäten 12 in den Schwingkreis auf das zu bearbeitende Bauteil vorzunehmen.

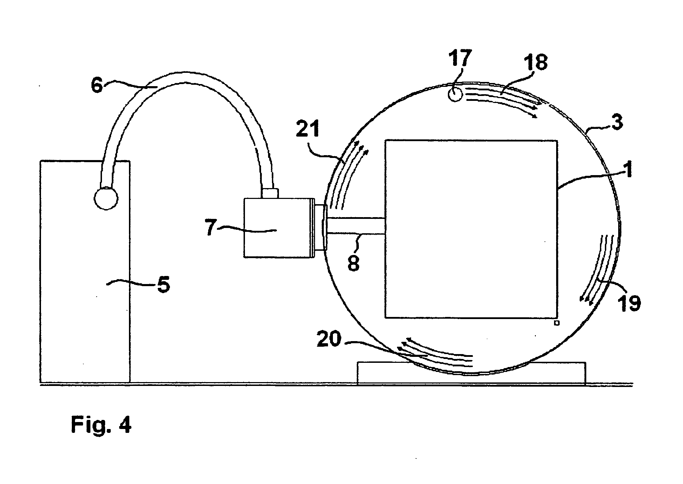

Figur 4 zeigt die Vorrichtung gemäß Figur 1 mit einem Rohr 17 nahe der Wand der Vakuumkammer 3. Auf die Darstellung der Schienen 2, der Isolation 4 und des Reflektors 10 wurde zur Vereinfachung verzichtet. Mit dem Rohr 17 wird das Stickstoffoxid in die Vakuumkammer 3 eingeleitet. Das Rohr 17 ist in dem nach oben weisenden Bereich der Vakuumkammer 3 angeordnet. Es verläuft unterhalb des in Figur 4 nicht dargestellten Reflektors, sofern die Vakuumkammer mit einem Reflektor ausgestattet ist. Es ist parallel zur Längsachse der länglichen Vakuumkammer ausgerichtet und verläuft damit senkrecht zur Bildebene der Figur 4. Die Wand des Rohrs 17 ist mit mehreren in der Zeichnung nicht erkennbaren Düsen ausgestattet, durch die das Stickstoffoxid ausströmt. Die Pfeile 18 deuten an, in welche Richtung das Stickstoffoxid aus dem Rohr 17 ausströmt. Die dem Rohr 17 zugewandten Enden der Pfeile 18 entsprechen dem Verlauf der Düsenachsen. Dieser ist parallel zu der nahe gelegenen Wand der Vakuumkammer 3. Unterstützt durch den runden Querschnitt der Vakuumkammer bildet sich eine Strömung des Stickstoffoxids entlang der Wand der Vakuumkammer aus. Die Strömung weist einen runden Querschnitt auf. Dies ist durch die Pfeile 19, 20 und 21 dargestellt. Das Stickstoffoxid umströmt das Bauteil 1. Aufgrund der kreisförmigen Strömung wird diese auch als Zyklonströmung bezeichnet.

Dem Stickstoffoxid können weitere Gase beigemischt werden. Es kann auch eine Mischung aus mehreren verschiedenen Stickstoffoxiden über das Rohr 17 in die Vakuumkammer eingeleitet werden. Das Rohr 17 mit seinen Düsen kann sowohl zum Einleiten des Arbeitsgases als auch zum Einleiten des oder der Trägergase dienen.

### Bezugszeichen

| | |
|---|---|
| 1 | Bauteil |
| 2 | Schiene |
| 3 | Vakuumkammer |
| 4 | Isolation |
| 5 | Hochfrequenzgenerator |
| 6 | Koaxial-Kabel |
| 7 | Außenschwingkreis |
| 8 | Hochfrequenz-Zuleitung |
| 9 | Hochfrequenz-Durchführung |
| 10 | Reflektor |
| 11 | Rückkoppelspule |
| 12 | Kondensator des Außenschwingkreises |
| 13 | Spule |
| 14 | Spule |
| 15 | Leitung |
| 16 | Senderöhre |
| 17 | Rohr zum Zuleiten des Stickstoffoxids |
| 18 | Pfeile zur Kennzeichnung der Strömungsrichtung des Stickstoffsoxids |
| 19 | Pfeile zur Kennzeichnung der Strömungsrichtung des Stickstoffsoxids |
| 20 | Pfeile zur Kennzeichnung der Strömungsrichtung des Stickstoffsoxids |
| 21 | Pfeile zur Kennzeichnung der Strömungsrichtung des Stickstoffsoxids |

## Patentansprüche

1. Verfahren zur plasmagestützten Oberflächenbehandlung großvolumiger Bauteile mit folgenden Verfahrensschritten:
Anordnen des Bauteils (1) in einer Vakuumkammer (3),
Evakuieren der Vakuumkammer (3),
Anschließen des Bauteils (1) an mindestens einen Schwingkreis (7) mit einem Hochfrequenzgenerator (5),
Abstimmen der Induktivität und/ oder der Kapazität des Schwingkreises (7) auf das Bauteil (1),
Einschalten des Hochfrequenzgenerators (5) und Zünden des Plasmas,
Einleiten mindestens eines Stickstoffoxids in die Vakuumkammer (3) als Arbeitsgas und/ oder als Trägergas,
Erzeugen einer elektromagnetischen Strahlung und/ oder freier Elektronen durch die Umsetzung des Stickstoffoxids in dem an der Oberfläche des Bauteils (1) brennenden Plasma,
wobei zusätzlich zu dem Stickstoffoxid oder den Stickstoffoxiden Excimere oder Exciplexe in die Vakuumkammer (3) eingeleitet werden.

2. Verfahren nach Anspruch 1, **dadurch gekennzeichnet, dass** zusätzlich als Arbeitsgas und/ oder als Trägergas Stickstoff und/ oder Ammoniak in die Vakuumkammer (3) eingeleitet werden.

3. Verfahren nach Anspruch 1 oder 2, **dadurch gekennzeichnet, dass** in die Vakuumkammer (3) als Trägergas ein Edelgas oder ein Stoff eingeleitet wird, der Sauerstoff bindet.

4. Verfahren nach einem der vorhergehenden Ansprüche, **dadurch gekennzeichnet, dass** das Trägergas und/ oder das Arbeitsgas über Düsen in die Vakuumkammer (3) eingeleitet wird, und dass mittels des Trägergases und/ oder des Arbeitsgases ein Teilchenstrom um das Bauteil (1) herum erzeugt wird.

5. Verfahren nach einem der vorhergehenden Ansprüche, **dadurch gekennzeichnet, dass** das Arbeitsgas und/ oder das Trägergas über Düsen parallel oder senkrecht zu einer Längsachse der Vakuumkammer (3) in die Vakuumkammer eingeleitet wird.

6. Verfahren nach einem der vorhergehenden Ansprüche, **dadurch gekennzeichnet, dass** das Arbeitsgas dem Trägergas beigemischt wird.

7. Verfahren nach einem der vorhergehenden Ansprüche, **dadurch gekennzeichnet, dass** mindestens eine Carbonyl-Gruppen enthaltende Verbindung in die Vakuumkammer (3) eingeleitet wird.

8. Verfahren nach einem der vorhergehenden Ansprüche, **dadurch gekennzeichnet, dass** eine Methylen oder Methylen-Gruppen enthaltende Verbindung in die Vakuumkammer (3) eingeleitet wird.

## Claims

1. Method for plasma-assisted surface treatment of large-volume components with the following procedural steps:
Arrangement of the component (1) in a vacuum chamber (3),
Evacuation of the vacuum chamber (3),
Connection of the component (1) to at least one oscillating circuit (7) with a high-frequency generator (5),
Adaptation of the inductance and/or capacitance of the oscillating circuit (7) to the component (1),
Switching on of the high-frequency generator (5) and ignition of the plasma,
Introduction of at least one nitrogen oxide in the vacuum chamber (3) as working gas and/or as carrier gas,
Generation of an electromagnetic radiation and/or free electrons by means of the conversion of the nitrogen oxide into the plasma burning on the surface of the component (1),
whereby excimers or exciplexes are introduced in the vacuum chamber (3) in addition to the nitrogen oxide or nitrogen oxides.

2. Method according to claim 1, **characterised in that** nitrogen and/or ammonia is additionally introduced in the vacuum chamber (3) as working gas and/or carrier gas.

3. Method according to claim 1 or 2, **characterised in that** an inert gas or a substance that binds oxygen is introduced in the vacuum chamber (3) as a carrier gas.

4. Method according to one of the previous claims, **characterised in that** the carrier gas and/or the working gas is introduced in the vacuum chamber (3) via nozzles and that the carrier gas and/or working gas is used to generate a stream of particles around the component (1).

5. Method according to one of the previous claims, **characterised in that** the working gas and/or carrier gas is introduced in the vacuum chamber (3) via nozzles parallel or vertically to a longitudinal axis of the vacuum chamber.

6. Method according to one of the previous claims, **characterised in that** the working gas is added to the carrier gas.

7. Method according to one of the previous claims, **characterised in that** at least one compound containing carbonyl groups is introduced in the vacuum chamber (3).

8. Method according to one of the previous claims, **characterised in that** a compound containing methylene or methylene groups is introduced in the vacuum chamber (3).

## Revendications

1. Procédé pour traitement de surface par plasma de composants de grand volume, comprenant les opérations suivantes :
disposition du composant (1) dans une chambre à vide (3),
production du vide dans la chambre à vide (3),
raccordement du composant (1) à au moins un circuit oscillant (7) doté d'un oscillateur haute fréquence (5),
ajustement de l'inductance et/ou de la capacité du circuit oscillant en fonction du composant (1),
mise en marche de l'oscillateur haute fréquence (5) et allumage du plasma,
introduction d'au moins un oxyde d'azote dans la chambre à vide (3) en tant que gaz utile et/ou gaz porteur,
production d'un rayonnement électromagnétique et/ou d'électrons libres par la réaction de l'oxyde d'azote dans le plasma brûlant à la surface du composant (1),
des excimères ou des exciplexes étant introduits dans la chambre à vide (3) en plus de l'oxyde d'azote ou des oxydes d'azote.

2. Procédé selon la revendication 1, **caractérisé en ce que** de l'azote et/ou de l'ammoniac sont introduits dans la chambre à vide (3) en tant que gaz utile et/ou gaz porteur.

3. Procédé selon la revendication 1 ou 2, **caractérisé en ce qu'**un gaz inerte ou une matière liant l'oxygène est introduit dans la chambre à vide (3) en tant que gaz porteur.

4. Procédé selon l'une quelconque des revendications précédentes, **caractérisé en ce que** le gaz porteur et/ou le gaz utile est introduit dans la chambre à vide (3) par des buses, et qu'un courant de particules est créé autour du composant (1) au moyen du gaz porteur et/ou du gaz utile.

5. Procédé selon l'une quelconque des revendications précédentes, **caractérisé en ce que** le gaz utile et/ou le gaz porteur est introduit par des buses dans la chambre à vide (3) parallèlement ou perpendiculairement à un axe longitudinal de la chambre à vide.

6. Procédé selon l'une quelconque des revendications précédentes, **caractérisé en ce que** le gaz utile est mélangé au gaz porteur.

7. Procédé selon l'une quelconque des revendications précédentes, **caractérisé en ce qu'**au moins un composé comprenant des groupes carbonyles est introduit dans la chambre à vide (3).

8. Procédé selon l'une quelconque des revendications précédentes, **caractérisé en ce qu'**un composé comprenant du méthylène ou des groupes méthylènes est introduit dans la chambre à vide (3).
